# EUROPEAN PATENT SPECIFICATION

(11) **EP 2 152 633 B1**
(45) Date of publication and mention of the grant of the patent: **06.10.2010**
(21) Application number: 08736827.0
(22) Date of filing: 11.04.2008
(51) Int. Cl.: C02F 1/02, C02F 1/54, C02F 101/20

(54) **METHOD FOR THE TREATMENT AND REUSE OF A STRIPPER SOLUTION**
VERFAHREN ZUR BEHANDLUNG UND WIEDERVERWENDUNG EINER STRIPPLÖSUNG
PROCÉDÉ POUR LE TRAITEMENT ET LA RÉUTILISATION D'UNE SOLUTION DE DÉCAPAGE

(30) Priority: 13.04.2007 FI 20070288
(43) Date of publication of application: 17.02.2010
(73) Proprietor: Yara Suomi OY, 00181 Helsinki (FI)
(72) Inventor: WECKMAN, Anders, FI-02770 Espoo (FI); JOKINEN, Juha, FI-02260 Espoo (FI)
(74) Representative: Svensson, Johan Henrik
(86) International application number: PCT/FI2008/050178
(87) International publication number: WO 2008/125728

(56) References cited:
- EP-A1- 0 429 044
- JP-A- 1 312 086
- JP-A- 11 021 681
- US-A1- 2003 200 838
- DATABASE WPI Week 200433 Thomson Scientific, London, GB; AN 2004-354430 XP002507565 -& TW 553 906 B (AMIA CO LTD) 21 September 2003 (2003-09-21)
- GYLIENE O ET AL: "METAL RECOVERY FROM SPENT ELECTROLESS PLATING SOLUTIONS BY OXALATE PRECIPITATION" PLATING AND SURFACE FINISHING, AMERICAN ELECTROPLATERS SOCIETY,INC. EAST ORANGE, US, vol. 82, no. 10, 1 October 1995 (1995-10-01), pages 61-63, XP000539377 ISSN: 0360-3164

## Description

### Field of the invention

The present invention relates to a method for treating spent stripper solutions for tin or tin mixtures by precipitating dissolved or suspended metal compounds. More specifically, the present invention is directed to a method for the treatment of waste water streams generated in electronic industry from stripping of tin and tin/lead to recover from the solution on the one hand chemicals for reuse and on the other hand metals such as copper, tin, lead, and/or iron.

### Background of the invention

Waste water containing, among other substances, heavy metals are generated as side streams in production plants for printed circuit boards (PCB). Said waste is typically transported and treated elsewhere for the recovery of constituents considered to be most valuable, and most readily isolable. However, all compounds of the waste slurry are not recycled.

In the USA and Europe, the most popular method for the treatment of the outer surface of PCBs is pattern coating. In this conventional production process for printed circuit boards, a tin, or a tin/lead layer serving as the layer resisting etching is produced by electric coating on a copper layer. After the non-circuitry regions of are removed by etching, a stripper, or a stripping solution based on nitric acid, is used in the next step for the removal of the electrically coated tin, or tin/lead layer to expose the copper circuitry.

Nitric acid or ferric nitrate is often used as the main stripping component in said strippers, or fresh etching solutions based on nitric acid. Typical composition comprises (as percentages, weight/weight) 10 to 40% of nitric acid, 1 to 10% of ferric ions Fe³⁺, < 1 to 2% of an anti-tarnish, and < 1 to 3% of an suspending agent. The exhausted solution should be replaced with fresh stripper solution when the concentration of free nitric acid, or of tin during stripping becomes less than 3.6 to 4.2 N, or more than 50 to 100 g/l, respectively, depending on the process conditions in the tin or tin/lead stripping module.

Suspending agents and anti-tarnish agents are additives of the stripper solution to maintain the properties thereof. During the stripping reaction, the elemental tin on the surface of the printed circuit board is oxidized to give Sn⁴⁺ ions that forms oxides or hydroxides of tin. Thus, tin is mainly present as SnO₂ in waste streams. It is known that most stannic(IV) salts are insoluble in water, not even in nitric acid. During stripping, the metal load in the solution increases, and further, metal compounds tend to precipitate from the solution to form a slurry. In applications using spraying, the slurry may cause clogging of the spray nozzles. This is prevented by the use of a suspending agent. Stannic(IV) oxide is kept dissolved and a finely divided stannic(IV) oxide suspension is formed in the stripper solution by said suspending agent. Said suspending agents are typically organic or inorganic acids. The stripper solution may become unstable once a certain metal load is reached. Under such exothermal conditions, great amounts of toxic NOₓ gases are released and stripping solution foams excessively. These undesirable conditions are a safety risk at the production plant and may damage the operating equipment. To avoid the problem, an anti-tarnish is used in the fresh stripper solution, said agent being an organic nitrogen compound without sulfur. Said organic additives not only act as nitric acid stabilizers, but are also believed to interact and/or form complexes with metal oxides and salts.

Once tin is removed from the desired sections of the printed circuit boards, the stripper used contains about 5 to 30% (weight/weight) of nitric acid, 1 to 10% (weight/weight) of ferric ions Fe³⁺ or Fe²⁺ ions, and minor amounts, i.e. < 1 to 2% (weight/weight) of an anti-tarnish agent, and < 1 to 2.5% of an suspending agent, 2 to 20 g/l of copper ions Cu²⁺, about 10 to 200 g/l of Sn⁴⁺ ions, and in some cases about 0 to 5 g/l of Pb⁴⁺ ions. It may also contain minor amounts of Sn²⁺ or Pb²⁺ ions in case of an incomplete oxidation, and further, minor amounts of other components.

### Treatment of the spent stripper solution for tin or tin/lead

Once the printed circuit board is treated, the stripper solution is acidic and typically comprises various acids, and partly dissolved and partly suspended metal compounds, and further, additives and derivatives thereof. Neutralization is a conventional treatment method of the spent stripper solution, carried out for instance by the addition of sodium hydroxide for the neutralization of free acid(s). Once the pH value is adjusted to the range of 8 to 13, most of the metal cations are converted to metal oxide or metal hydroxide precipitates. After filtration, they may be further processed for the recovery of metallic tin, iron, copper or lead. Thereafter, the filtrate thus obtained is evaporated to produce sodium nitrate crystals. While metals may be satisfactorily recovered, the possibility for the recirculation of the solution is lost. In this method, use of high amounts of sodium hydroxide is necessary, and moreover, the sodium nitrate crystals thus obtained have no commercial value.

An alternative method is disclosed in the patent application US 2003/0200838 having the title "A method for the treatment of spent tin-lead stripping solution" wherein electrolytic copper removal is followed by the precipitation of the stannic(IV) and lead(II) components of the spent stripper solution by heating. According to this reference, the temperatures remain below values, at which nitric oxides are released from the solution. The precipitate is removed and dissolved in a base or a strong acid, followed by electrolytic reduction of the metals. This method is complicated and comprises several steps and multiple unit operations. Moreover, it is necessary to add chemicals during various stages, thus increasing costs and reducing profitability.

Japanese patent application JP 11021681 discloses a method for precipitating metastannic acid and copper from a stripper solution. This is accomplished by heating the spent stripper solution at 50 to 70°C, causing the metastannic acid to separate from the liquid by sedimenting in 3 to 8 hours. The precipitate is removed by decanting, filtering, or centrifugation. The possibility to reuse the solution is mentioned in the document in case copper is also removed by electrolysis. Regeneration of the solution for reuse is not described.

Recovery of metals is the main object in all these methods representing the prior art. In the methods, the removal of the metals is typically carried out as a separate process with its respective unit operations. In case the solution is recovered, the regeneration thereof is performed just prior to novel stripping for tin removal in a step separately from precipitation and purification of metals.

An abstract of a Taiwanese patent publication 553,906 titled "A method for the treatment of waste tin-lead stripping solution" teaches a multistep method wherein stannic and plumbous components of the spent stripping solution are first oxidized, the spent solution being heated. Precipitate is removed and dissolved in alkali or a strong acid and then reduced electrolytically. Copper is recovered cathodically from the filtrate.

Prior art document EP0429044 A discloses a process of treating aqueous solutions for recovering metals in the form of bivalent ions in addition to other dissolved substances. The method starts with adjusting the pH of the solution to a value of 0,1 to 8. Then sufficient amount of oxalic acid is added to allow for the metals to be recovered and the solution is heated to a temperature of between 20 and 100°C. Final step is isolating the metal oxalate precipitate formed and heating same to a temperature above its decomposition temperature.

A publication by Gyliene and Salkauskas reports removal of Cu(II), Ni (II) and Co(II) from acidic solutions containing sulphuric, nitric, hydrochloric or phosphoric acid. Said method comprises addition of oxalic acid to solution containing metals and subsequent addition of a strong base (KOH or NaOH) in room temperature to adjust pH between 5 and 6. The precipitation takes up to five days to settle so that it can be filtered. The aim is to recover copper and complexing agent EDTA. Acids, however, are neutralised.

Abstract of JP 01312086 A discloses a method for removing tin from a waste solution by heating to 50-70 °C to precipitate metastannic acid and remove said precipitate. From remaining solution copper and lead are removed.

Recovery of metals is the main object in all these methods representing the prior art. In the methods, the removal of the metals is typically carried out as a separate process with its respective unit operations. In case the solution is recovered, the regeneration thereof is performed just prior to novel stripping for tin removal in a step separately from precipitation and purification of metals.

There is still a need for an alternative method for treating spent tin and tin/lead stripper solutions to recirculate the reagents as completely as possible and to recover metal oxides in an environmentally acceptable, simple, and efficient manner, and particularly to maintain the stripping performance and capacity of the stripper solution in the liquid phase.

### Summary on the invention

The object of the present invention is to provide a treatment method of the solution for stripping tin to recover chemicals having reuse value. Aqueous solutions of the reactive acid are a particularly desired component for recycling, said solution comprising other agents that are necessary in the fresh solution and/or non-detrimental. According to the invention, the stripper solution is processed by a method comprising heat treatment and addition of a reagent producing oxalate, said method providing an alternative to and having certain advantages with respect to known methods. It was surprisingly found that the efficiency of the removal of the metal derivatives is improved and at the same time the amount of the necessary regeneration reagents is decreased by the addition of reagents necessary for the regeneration of the stripper solution prior to the removal of the excessive tin and other metal ions from the spent stripper solution. The remaining liquid phase then comprises at least nitric acid, possibly oxalic acid and iron derivatives, but only insignificant amounts of copper, tin or lead derivatives, the liquid being thus suitable for reuse as such or after an additional treatment.

Under these conditions, at elevated temperatures and in the presence of oxalate, the waste stream suspension is clarified. The composition remaining dissolved under stripping conditions is now separated by the method to yield a solid phase and a liquid phase. Once the mixture is cooled, said two phases may be readily separated by decanting, filtering, centrifugation, or by any conventional technique. The metal content of the solid phase is high.

The present invention also provides the advantage that after the treatments according to the method, the solution obtained may be recirculated to the process for stripping tin or tin/lead, and thus it is necessary to add fresh reagents in considerably lower amounts than in alternative methods.

An advantage of the invention is also the fact that the volume of the waste containing heavy metals formed during the production of printed circuit boards is reduced, thus decreasing the environmental load.

### Detailed description of the invention

The present invention describes a method for the treatment of a spent solution used for the stripping of tin or a tin alloy. It is desired to remove the copper ions, tin ions and in some cases the lead ions from the solution. Ferric ions, benzotriazole and as high stripping capacity as possible, in practice acids, may remain in the solution. The object is to recover the stripping capacity of the stripper solution for reuse by precipitating dissolved or suspended metal compounds therefrom. It has now been found that surprisingly good results may be obtained by improving the efficiency of the precipitation by a procedure involving heating the stripper solution and adding an oxalate forming reagent.

Stripping capacity of a solution means the ability thereof to strip tin from the surface of the printed circuit board. Nitric acid used in the solution has the greatest influence on the stripping capacity. The stripping capacity is also influenced by other inorganic and organic acids. The stripping capacity is lowered by the consumption of the acid for the oxidation of elemental metals, and metal ions in the solution, and further, if the metal ions in the solution bind the stripping capacity for instance by sequestering. On the contrary, capacity is released if metal ions exit, or are removed from the solution.

Efficiency of the precipitation of tin is increased by the heat treatment according to the invention at a temperature of 75 to 100°C. In the literature, for instance in the English translation of the document JP 11021681, heating at 50 to 70°C is used as the method for treating the stripper solution, while knowingly and carefully avoiding temperatures exceeding 70°C due to increased and uncontrolled release of nitrogen oxides. In the literature, this is commonly considered as an undesired phenomenon to be avoided.

However, contrary to the predominant opinion of those skilled in the art, it was found in the present invention that quick precipitation reactions are particularly effective at such high temperatures, at which nitrogen oxides are released. Under such conditions, the method of the invention may be controlled, the advantages attained being more significant than said drawbacks. Release of nitrogen oxides is an equillibrium reaction where gasses are released but also dissolved in the solution in great amounts, particularly in large scale tests where gasses are not considered as a disadvantage. Gaseous compounds may be recovered from the reactors by means of conventional gas stripping arrangements.

Precipitation of copper in the form of oxalate is known as such in the art. Copper oxalate is poorly soluble in water and in the medium of the tin stripper solution containing nitric acid. Precipitated copper oxalate is, however, lightweight, consists of small crystals, and has a density not differing sufficiently from that of the stripper solution to be efficiently separated from the solution. It is not practical to remove copper by the direct addition of oxalic acid to the tin stripper solution since oxalic acid first reacts with tin causing high consumption of the chemicals intended for copper precipitation. Accordingly, the precipitation of copper by the sole addition of oxalate is not a useful method for the treatment of the stripper solution.

According to the invention, heating is carried out prior to the addition of the reagent forming oxalate. It was found in this connection that heating causes the precipitation of tin present in the spent stripper solution in the form of tin compounds. Thus a higher proportion of the reagent to be added, forming oxalate (oxalic acid, soluble salt of oxalic acid or the like), may react with copper and form poorly soluble copper oxalate. Precipitation of copper in the form of copper oxalate was shown in the method of the invention. That is, if oxalate is added first, the result in this case would also be in the desired direction, i.e. metals would precipitate from the solution, but also tin would react and consume oxalates. More copper is removed from the solution by a certain amount of oxalate reagent added after heating than by the same amount of the reagent without prior heat treatment.

An embodiment of the method of the invention where at least 60% nitric acid is added to the spent stripper solution prior to the heat treatment is shown to be particularly effective. The amount of the nitric acid to be added relative to the amount of the stripper solution is determined in percentage, calculated as 100% nitric acid. It is thus clear to those skilled in the art that if for instance 3% by weight of nitric acid, the form of e.g. a 60% nitric acid solution, should be added relative to the amount of the stripper solution, then said 60% nitric acid solution is added in an amount of 5% by weight based on the amount of the stripper solution. A method where first nitric acid is added, followed by heating the solution for a predetermined period is disclosed in a previous publication No. WO2007042611. It was found in the said method that metal compounds released during stripping are kept in a complexed form and/or suspended in the liquid phase by an organic amine used as a stabilizer for nitric acid. Efficiency of the precipitation of metal compounds and sedimentation thereof as precipitates may be improved by influencing this particular additive and its equillibrium to cause its conversion to derivatives. It is, however, surprising to those skilled in the art that the equillibrium in the solution may be disturbed to cause precipitation of metal compounds by the addition of relatively low amounts of a reagent, here nitric acid, already present in the stripper solution.

Organic additive comprises an organic amine, preferably benzotriazole. In the aqueous solution, said organic amine is in the form of a salt, typically a halide and particularly a chloride salt. In a method according to publication No. W02007042611 the conversion of the organic additive was particularly desired, thus causing the equillibrium to shift in the solution to a direction where the precipitation and sedimentation of the tin compounds from the dispersion is accelerated. In said method, the additive was removed with the precipitate and the addition thereof was necessary for the regeneration of the stripper solution. On the contrary, said additive according to the present invention remains in the solution, and maintains its properties, and accodingly, the addition of only low amounts thereof is necessary for the regeneration.

A certain amount of nitric acid is necessary for the desired effect in the precipitation of tin. In the range between 3 and 7% by weight, a correlation between the amount of the nitric acid addition and precipitation of tin may be seen. The influence of the nitric acid addition is seen as larger size of the crystals formed and improved sedimentation from the solution. Precipitating efficiency is no longer improved by a nitric acid addition above 8% by weight, based on the total weight of the stripper solution, and 100% acid, but steaming of the stripper solution and the formation of nitrogen oxides are accelerated. For this reason to improve the efficiency of the precipitation, nitric acid should be added in an amount of 3 to 7% by weight, calculated as 100% acid, or in a corresponding amount of diluted (> 60%) nitric acid relative to the total weight of the spent stripper solution. Added amounts of nitric acid are discussed in the patent publication No. W02007042611.

According to an embodiment, oxalate is added to a solution having a temperature of 20 to 60°C. Decarboxylation of oxalix acid by heating is a typical reaction for a β-diacid, and it is described in the basic textbooks of organic chemistry (e.g. Organic Chemistry, Fessenden & Fessenden, Brooks/Cole Publishing Company, 1990, USA). Due to decomposition of oxalic acid, the addition of the oxalate reagent to the solution at the temperature of the heat treatment is not efficient. Under the conditions of the tin stripper, during heating to 85°C, the oxalic and nitric acids partly decompose to yield NOₓ gases and CO₂. Metals (such as Mn²⁺) effect by deteriorating oxalate stability. It was experimentally found that after said heating, it is preferable to allow the solution to cool or to cool the solution to a temperature below 60°C. A temperature ranging between 40 and 60°C is preferable since only a small reduction of the temperature is then necessary, the reactions, however, proceeding more quickly at higher temperatures.

Oxalic acid is preferably added to the spent stripper solution in a solid form, or already dissolved to a predetermined concentration. Quicker start of the reactions is an advantage attained with dissolved oxalate additive. Oxalic acid also contributes to the stripping capacity, that is, to the acidity. The addition of the oxalate is also referred to as "oxalate treatment". In this embodiment of the invention, the object is to precipitate copper in the form of oxalate. For this reason, corresponding effect is obtained by the addition of some soluble oxalate. It is also known that under the conditions of the spent stripping solution, some other organic compounds may react to give oxalic acid or oxalates. One of these compounds is sugar, more spesifically, saccharose. Oxalate activity is thus obtained by the addition of one or more reagents forming oxalate to the stripper solution, the reagents being selected from the group consisting of solid or dissolved oxalic acid, soluble oxalate salt, or an organic compound reacting to give oxalate under the conditions of the stripper solution.

Here, the terms "a reagent producing oxalate", "a reagent releasing oxalate", and "a reagent forming oxalate" refer to oxalic acid, readily soluble oxalate salts, and such organic compounds that decompose under the conditions in the solution for stripping tin, or otherwise react to yield oxalic acid, or oxalates. These compounds include e.g. some monosaccharides or disaccharides, such as saccharose.

The effect of the amount of the oxalate addition of the invention on the precipitating efficiency was quantitatively studied. Best results were obtained in embodiments and under experimental conditions where the relative amount of the reagent forming oxalate was 3 to 8% by weight as oxalate, based on the total weight of the stripper solution. Besides copper concentration, the degree of supersaturation necessary for the reaction to start, and other ions in the solution consuming oxalate should be taken into consideration for the oxalate addition. That is, no desired effect on the precipitation of metals, particularly copper, was achieved with reagent additions below a certain observed threshold value. However, above this threshold value, linear dependence between the added oxalate amount and the precipitated copper amount was observed.

The proper oxalate amount is selected on the basis of, and the best precipitation results obtained depend on said threshold value determined by the supersaturation and temperature, said temperature having its own optimum. This threshold value may be experimentally determined for each spent stripper solution by the addition of oxalate to a sample having a constant size until the colour of the precipitate formed becomes green. An oxalate addition above this amount, and thus necessary in addition to said amount, depends on the amount of copper in the solution, and may be calculated on the basis of the known copper content.

In case the solution is recycled for reuse in the stripping of tin, excessive oxalate may be detrimental if oxalate already reacts with copper during the stripper treatment. For this reason, the optimal oxalate amount depends on the amount of bivalent metals in the spent solution for stripping tin. Basically, the oxalate amount depends on the amount of copper in the solution. In practice it was found that oxalate should be present in the solution for stripping tin in amounts six times higher than that of copper analysed in the solution, or even more, that is in 8-fold or 16-fold amounts. The amount may be explained by taking into consideration other metal ions besides copper consuming oxalate. In this case, the calculated molar oxalate amount should be twice the amount of metal ions present in the solution. High oxalate addition is necessary if the solution contains great amounts of metal ions, i.e. if a high proportion of the "stripping capacity is bound". However, if suspended metals are present in relatively lower amounts in the spent solution to be treated, then an unadjusted oxalate addition may even result in an excessive oxalate amount remaining in the solution, possibly disturbing the following step for stripping of tin. Therefore, it should be understood that a person skilled in the art is able to adjust the amount of oxalate necessary for the treatment. Excessive oxalate may also be removed from the solution prior to a further stripping, for instance by heating or using manganese. It was, however, found in the large scale tests that the removal of oxalate or copper oxalate is not necessary. When the recirculated stripper is reused, it will be mixed with a fresh stripper resulting in dissolution of precipitates.

Oxalic acid may displace benzotriazole on the tin particles in a similar manner or even more efficiently than nitric acid, thus contributing to precipitation. Tin removal is improved by the combined nitric acid and oxalate additions in comparison to separate additions of each reagent.

The precipitate formed by the reactions of said nitric acid and oxalate additions is preferably separated and removed from the solution. As an alternative, the apparatus may be arranged for instance to remove some solution for reuse near the surface of the reactor either batchwise or continuously while the slurry remains on the bottom of the apparatus and is periodically removed. Precipitates of said metal compounds are preferably at least once separated from the solution during or after the nitric acid or oxalate additions prior to the reuse of the solution for stripping.

According to an embodiment, precipitate of metal compounds is separated from the solution after nitric acid addition. Some compounds of tin are typically precipitated in this stage. Copper compounds are not precipitated under these conditions but mainly remain in the solution.

Precipitates of metal compounds may be separated from the solution also during heating using specific technical arrangements. An advantage of such continuously operating arrangements is the fact that reaction equillibriums may be influenced to leave free reaction capacity in the solution, thus allowing for further precipitation reactions. At the same time, the crystal size of the precipitating particles may be influenced by the faster removal of readily precipitating larger particles than that of smaller ones, allowed to grow in the solution for a longer time. In the continuous embodiment, the mean residence time is the same as in batchwise crystallization.

As an alternative or in addition to the above procedure, precipitate of metal compounds may be separated from the solution after heating. After heating, the reaction is as complete as possible, and the precipitate formed may be removed at once as completely as possible. The fact that heating is completed may also be considered as an advantage of the method, and if the solution is allowed to cool or cooled, the separation is technically simpler in some cases. In addition, the solubility in the cooler solution is lower, and thus the yield of the precipitate is typically better than that from a warmer solution.

According to an embodiment, the precipitate of metal compounds is separated from the solution during oxalate addition. If oxalate is added to a solution, from which the precipitate formed in the previous step is removed, then oxalate salts of bivalent metals, mainly copper oxalate, may be recovered in this step, but also tin reacts consuming oxalate. Some precipitate formed in the previous step may still be present in the reactor. Alternatively, precipitate of metal compounds may be separated from the solution only after the oxalate addition, or optionally both during and after the addition.

According to a particularly preferable embodiment of the method, the solution is heated for a certain period of time at about 85 to 90°C. In this stage, heavy tin oxide particles are precipitated, still remaining in the reactor. Once the temperature of the solution is below 60°C, oxalate is added, for instance in the form of solid oxalic acid. This addition results in the precipitation of copper in the form of copper oxalate, and also of tin compounds in minor amounts. Precipitates formed during heating and the addition of the reagent forming oxalate are removed at once in a single separation step. Mixed precipitate separates and sediments more readily to the bottom than a precipitate consisting of only copper oxalate.

Without wishing to be bound by any theories, it is believed that once copper is removed from the solution, the altered solubility conditions contribute to oxidation and precipitation of additional amounts of tin. The relatively lightweight unsedimented copper oxalate precipitate is also believed to adhere on the surface of the more dense and heavier precipitated and precipitating tin compounds still present in some amounts in the solution, and to sediment therewith. The advantage of this is that more metals, particularly tin, may be removed from the solution by the combined action of heating and oxalate compared to the separately performed treatments.

Alternatively, this embodiment comprising a single solid/liquid separation may also be carried out by adding nitric acid having a concentration of > 60 to 100% prior to heating to improve the efficiency of tin precipitation, followed by a procedure as explained above.

The recovery of different metals for purification and reuse from the precipitate obtained with the method of the invention is technically possible and may be performed in a feasible manner. With respect to the contents of different elements, analyses have shown that the solid matter recovered is very suitable for reuse.

The term "regeneration" used in the specification refers to the supplement of the aqueous solution obtained after the treatment to the desired acidic normality and to the desired concentrations of other chemicals essential in the process such as ferric ions, suspending agent, and organic amine playing a role in the achievement of an efficient stripping action in the production of printed circuit board using a stripping solution for tin.

In this connection, "a stripping solution for tin" and "a stripper solution" refer to a reagent mixture containing nitric acid, possibly other organic or inorganic acids, oxides and salts of iron, copper, tin, and/or lead, as well as an organic stabilizer for nitric acid. Various compositions are known from the literature, but in general, a stripper based on nitric acid with its variations according to the specific process and production plant may be mentioned. In general, the term "solution" refers to spent and fresh solutions for stripping tin or tin/lead, notwithstanding in fact that after stripping, SnO₂ is dispersed in the liquid phase and thus a kind of a slurry is obtained. This expression being widely used in the art, it is also used in this connection.

Inorganic acids refer to inorganic acids present in the waste solution. In case of the spent solution for stripping tin or tin/lead, the acid is mainly nitric acid, the others being suspending agents to prevent the precipitation of metal oxides and to keep them in the aqueous phase for the most part. Typical suspending agents include inorganic acids such as hydrochloric acid, nitric acid, sulfuric acid, fluoroboric acid, boric acid or chlorine acid.

The patent of Kawanabe (US Patent No. 4,374,744) discloses that also organic acids may be used as suspending agents. These include oxalic, acetic, propionic, gluconic, tartaric, or formic acid. In this connection, these acids, and stabilizers of nitric acid described below are covered by the term organic additive compounds.

Thus, a significant advantage of the use of the method of the present invention is the fact that only such chemicals that may be used to produce a fresh solution are added during the process. As a substantial amendment of the method, the reagent forming oxalate is one of the organic acids, the use of which was mentioned by Kawanabe in his patent. As stated above, in case oxalic acid is used, the amount to be added is a matter of concern since an excess remaining in the stripper may be harmful. The problem is under control when operating in the range according to the claims. Another optional amendment of the method is the addition of 60 to 100% nitric acid prior to heating. Nitric acid is the main constituent of the stripper not interfering with stripping if present in amounts described.

The fact that only reagents useful for the reuse of the stripper are added during the treatment of the invention results in certain advantages for reuse. The composition of the regenerated solution for stripping tin or a tin mixture, comprising at least one inorganic acid, at least one organic acid and at least one organic additive, may be adjusted in a very simple manner as desired. The fact that most of the acids and for instance benzotriazole used as an additive may be recyced is economically significant. In the production process of printed circuit boards, the stripper is typically diluted, thus making the addition of ferric ions also necessary. For reuse of the solution, the regeneration comprises heating and the addition of the reagent forming oxalate, the complete regeneration thus comprising the following steps:
a. heating of the stripper solution at 75 to 100°C for 0.5 to 3 hours,
b. addition of the reagent forming oxalate,
c. separation and removal of the precipitated matter,
d. addition of one or some of the acids or additives mentioned to recover the desired tin stripping capacity.

According to a preferable embodiment, said steps a., b., c., and d. are successively performed in the order shown.

In the method, 60 to 100% nitric acid may be added as described above in an amount of 3 to 7% by weight calculated as 100% nitric acid and based on the total weight of the stripper solution prior to heating, or step a. In the step a., the particularly preferable temperature range is from 85 to 90°C.

However, in the step b., the temperature should be between 30 and 60°C. Best results are obtained in the range from 40 to 60°C.

In the step c., a solid matter is obtained, having suitable properties for reuse. Copper compounds and/or tin compounds are the most valuable. Optionally, some of the solid matter may be simultaneously removed in step a. and/or b. It is also possible that after the step a., precipitated matter is removed.

Using the described method, also the regenerated stripper solution is obtained as a valuable product in addition to the recovered precipitates. The properties thereof are suitable for reuse as the stripper solution in the production of printed circuit boards. Best results are obtained with the regenerated stripper solution used together with a fresh solution. It is particularly preferable to add most of the recycled regenerated solution and only a minor proportion of a fresh stripper. The ratio of the solutions mentioned above is preferably 80:20, respectively. Even higher proportions of the recycled stripper are sought after and probably possible. Recycled stripper may of course be used less than the fresh one. The use of the regenerated stripper solution in the mixing ratio of 1:1 with the fresh solution is given as an example. The properties of the regenerated solutions of the invention were very suitable for the desired purpose: the solution was clear, and further, the apparatus was not damaged, tin was quickly stripped, and clear and shiny surfaces were produced by the solution.

For recycling, it is possible to carry out only certain process steps during each regeneration, that is, all steps of the method may be performed for only part of the recycled streams.

The purpose and advantages of the present invention are described in more detail by means of the following non-limiting examples.

### Examples

### Test 1, comparative example

To a spent solution for stripping tin, from which Sn was alredy separated by precipitation, oxalic acid was added in solid form (Table 1), or as a 12.5% solution (Table 2) at a temperature of 20°C. Clarity of the solution and precipitation therein was monitored. In test series where solid oxalic acid was added, copper content of the clarified solution was analyzed in 10 days.

**Table 1**

| Oxalic acid added in solid form | | | | | | | | | |
|---|---|---|---|---|---|---|---|---|---|
| No. | Oxalic acid/ Cu (mol/mol) | Sn-depleted solution, g | Oxalic acid, g | **10d supernatant Cu,** % | 5 min | 0.5 h | 1 h | 2 h | 10 d |
| | | | | | | | | | |
| 1A | 0.5 | 80 | 0.2 | **0.35** | clear | clear | clear | clear | green solution, pale precipitate |
| 2A | 1 | 80 | 0.4 | **0.35** | clear | clear | clear | turbid, precipitate on the bottom | green solution, pale precipitate |
| 3A | 2 | 80 | 0.8 | **0.35** | clear | slightly turbid | turbid, no precipitate on the bottom | turbid, precipitate on the bottom | green solution, pale precipitate |
| 4A | 4 | 60 | 1.2 | **0.35** | clear | turbid | turbid, precipitate on the bottom | turbid, precipitate on the bottom | light green solution, pale precipitate |
| 5A | 8 | 60 | 2.4 | **0.13** | clear | decoloration, slightly turbid | turbid, no precipitate on the bottom | turbid, precipitate on the bottom | brown solution, green precipitate over a pale precipitate |
| 6A | 16 | 50 | 4 | **0.022** | turbid | lots of precipitate | turbid, clarifying, colour different | turbid, precipitate on the bottom | brown solution, green precipitate |

**Table 2**

| Oxalic acid added as a solution | | | | | | | | |
|---|---|---|---|---|---|---|---|---|
| No. | Oxalic acid/ Cu (mol/mol) | Sn-depleted solution, g | 12,5% oxalic acid solution, g | Time to start of precipitation | 0.5 h | 1,5 h | 3 h | 5 h |
| 1 | 0.5 | 80 | 1.6 | no precipitation | unchanged | clear | clear | clear |
| 2 | 1 | 80 | 3.2 | 2 h | unchanged | slightly turbid | turbid, small amount of pale precipitate | turbid, pale precipitate on the bottom |
| 3 | 2 | 80 | 6.4 | 1 h | unchanged | precipitate half of the amount in 4-6 | turbid, pale precipitate more than in 2 | turbid, pale precipitate on the bottom |
| 4 | 4 | 60 | 9.6 | 10 min | slight sedimentation | precipitate sedimented | turbid, pale precipitate more than in 3 | turbid, pale precipitate on the bottom |
| 5 | 8 | 60 | 19.2 | starts instantly | one half clarified | precipitate sedimented | turbid, pale precipitate more than in 4 | turbid, pale precipitate on the bottom |
| 6 | 16 | 50 | 32 | starts instantly | one half clarified | precipitate sedimented | turbid, green precipitate as in 4 | slightly turbid, green precipitate on the bottom |

Precipitation began in a slightly shorter time with predissolved oxalic acid than with solid oxalic acid. After 10 days, the copper content was analysed from clear solutions for the test series where solid oxalic acid was used. Excess of oxalic acid was necessary to remove copper in the reaction.

### Test 2

Spent tin stripper was heated at 85°C for 1 h (A). 8% by weight of HNO₃ (having a concentration of 62%) was added to the spent tin stripper, hollowed by heating at 85°C for 1 h (B). 4% by weight of oxalic acid was added to the spent tin stripper, followed by heating at 85°C for 1h (D). Sn-depleted solution served as the control (C) 4% by weight of oxalic acid was added to the solutions A, B and C at a temperature of 40°C, and agitated for 20 minutes. Volumes of the precipitate and supernatant, or separated solution, and proportions thereof were measured from the solutions (Table 3). Copper and tin contents were also analysed (Table 4). Tables 5 and 6 summarize observations during the precipitations at certain observation times.

Precipitated were separated from the solutions A, 8 and C using a laboratory centrifuge (20 min / 13 000 rpm).

**Table 3**

| Supernatant, % by volume | | | | | |
|---|---|---|---|---|---|
| **Time, h** | **A** | **B** | **C** | **D** | **Supernatant sample taken** |
| 1 | 12.5 | 2.6 | 0 | | |
| 1.75 | 27.5 | 5,1 | 0 | | |
| 2 | 32.5 | 10.3 | 12.5 | | |
| 2.5 | 37.5 | 12.8 | | 3 | |
| 3 | 45 | 12.8 | 25 | | |
| 3.5 | 50 | 17.9 | 55 | | |
| 4.5 | | | | 8 | |
| 22 | | | | 39 | |
| 25 | | | | 42 | sample D |
| 28 | | | | 42 | |
| 2d | | | | 67 | |
| 3d | | | | 72 | samples A, B, C |

**Table 4**

| Analyses of the metal contents | | | | |
|---|---|---|---|---|
| | A | B | C | D |
| Solution | | | | |
| **Cu %** | **0.21** | **0.21** | **0.20** | **0.30** |
| **Sn-% Precipitate,** | **0.56** | **0.6** | **0.63** | **0.51** |
| **% by weight** | **14.4** | **13.8** | **1.7** | |

**Table 5**

| Visual monitoring of precipitation | | | | |
|---|---|---|---|---|
| **Hours** | **A 400 ml** | **B 390 ml** | **C 400 ml** | **D 360 ml** |
| 0 | clarification starts immediately | | decoloration | |
| | | | turbid (remained clear | |
| | | 10 ml of clear | at the beginning for | |
| 1 | 50 ml of clear solution | solution | nearly 1 h) | |
| 1.75 | 110 ml of clear solution | 20 ml of clear solution | turbid | |
| 2 | 130 ml of clear solution | 40 ml of clear solution | about 50 ml of clear solution | |
| | | | | 10 ml of clear |
| 2.5 | 150 ml of clear solution + white layer of about 90 ml on the bottom | 50 ml of clear solution | clear, not so clear as A and B | solution. Not as clear as A and B |
| 3 | 180 ml of clear solution + white layer of about 100 ml on the bottom | 50 ml of clear solution | about 100 ml, clearer + thin white precipitate layer on the bottom | |
| | | | about 220 ml, clearer + | |
| 3.5 | 200 ml of clear solution+ white layer of about 110 ml on the bottom | 70 ml of clear solution | thin greenish precipitate layer on the bottom | |
| 4.5 | | | | 30 ml of clear solution. Not as clear as A and B |
| | | 290 ml of clear | | |
| | | solution (A is | 320 ml of clear solution (more turbid than B) | |
| | 290 ml of totally clear solution | brighter) 100 ml of precipitate | | |
| 24 | 110 ml of precipitate | | 80 ml of precipitate | |

Here, a solution having the temperature of 40°C was subjected to the oxalate treatment. Sample D served as the control, comprising heating of the solution at 85°C after the addition of oxalic acid. The test showed that the addition of the oxalate reagent to the solution at the temperature of the heat treatment is not efficient due to decomposition of oxalic acid. It was experimentally found that after said heat treatment, the solution is preferably allowed to cool, or cooled to a temperature below 60°C. A temperature from 40 to 60°C is preferable since only a relatively small reduction of the temperature is then necessary.

### Test 3 (comparative example)

Two spent solutions for stripping tin, comprising precipitated tin, were subjected to a series of oxalic acid additions at room temperature (Tables 6 and 7), agitated for 15 minutes, and placed in a thermal cabinet for 24 hours at 60°C. In the first solution (decanted filtrate C), the tin slurry is still present, whereas tin is removed from the second solution (heavy solution D of a separator). Settling was monitored for 1.5 hours, eventually determining the colours of the solution and the precipitate (Table 8). Copper contents were analyzed from clear solutions (Tables 6 and 7).

**Table 6**

| Serial oxalic acid additions to decanted filtrates | | | | | |
|---|---|---|---|---|---|
| **Decanted filtrate** | Oxalic acid/Cu (mol/mol) | Sn-depleted solution, g | g | Oxalic Cu, acid, g | Supernatant, Cu, % |
| **D** | 6 | 100 | 0.35 | 3 | **0.33** |
| **E** | 8 | 100 | 0.35 | 4 | **0.26** |
| **F** | 10 | 100 | 0.35 | 5 | **0.17** |
| **G** | 12 | 100 | 0.36 | 6 | **0.11** |

**Table 7**

| Serial oxalic acid additions to separator solutions | | | | | |
|---|---|---|---|---|---|
| **Heavy solution of the separator D** | Oxalic acid/Cu (mol/mol) | Sn-depleted solution, g | Cu, g | Oxalic acid, g | Supernatant, Cu, % |
| **H** | 6 | 100 | 0.35 | 3 | **0.27** |
| **I** | 8 | 100 | 0.35 | 4 | **0.22** |
| **J** | 10 | 100 | 0,35 | 5 | **0.16** |
| **K** | 12 | 100 | 0,36 | 6 | **0.12** |

Copper analyses were performed using very well clarified clear supernatants.

**Table 8**

| Visual monitoring of volume ratios during precipitation | | | | | | | |
|---|---|---|---|---|---|---|---|
| | Clear solution initially, % by volume | Initial colour of the solution | Initial colour of the precipitate | 1.5 h clear solution, % by volume | 8 h precipitate, % by volume | 18 h colour, solution | 18 h colour, precipitate |
| **D** | 23 | green | | 40 | 32 | green | pale |
| **E** | 23 | green | | 38 | 32 | green | greenish |
| **F** | 23 | green | | 36 | 32 | brown | greenish |
| **G** | 23 | brown | | 36 | 32 | brown | green |
| **H** | | green | pale | | 11 | green | green |
| **I** | | green | pale | | 11 | green | greenish |
| **J** | | green | green | | 11 | green | green |
| **K** | | brown | green | | 11 | brown | green |

In cases where the tin precipitate was still present (Table 6), the precipitation of copper with low dosages was not as efficient as in case of clear solutions (Table 7). No difference was seen for higher oxalic acid dosages. Precipitation of copper may be seen (Table 8) on the basis of the green colour of the precipitate, while the brown colour indicates that the purification of the solution was succesful.

### Test 4

Fresh starting solution comprised only a minor amount of precipitate already settled, and clarification thereof failed even after a long storage. The solution contained 0.38% of Cu, 1.6% of Fe, 4.2% of Sn, 0.91 % of C, 5.5% N, 0.89% CI.

In this starting solution that was only heated (85°C, 1 h) and stored at room temperature without any oxalic acid addition, a precipitate layer was settled on the bottom, but however, the supernatant was not completely clear.

In two parallel tests, the effect of preheating on the removal of tin and copper removal was compared using oxalic acid additions. In the test M1, the spent tin stripper was heated at 85°C for 1 h, oxalic acid was added in an amount of 6% at 43°C, and the stripper was left at room temperature. In the test M2, the spent tin stripper was added with oxalic acid in an amount of 6% directly at room temperature. Separation was monitored by measuring the volume ratios of the precipitate to the clear solution (Table 9). Moreover, metal contents were analyzed from the samples, Sn and Cu analyzed (Table 10).

**Table 9**

| Phase separation of the samples M1 and M2 | | |
|---|---|---|
| Time, h | M1, vol-% | M2, vol-% |
| 0.5 | 25 | 0 |
| 1 | 54 | 0 |
| 1.5 | 69 | 0 |
| 2 | 71 | 0 |
| 20 | 73 | 54 |

M1 settled well, giving a brown solution and a green precipitate. Settling of M2 was slower, resulting in a pale brown turbid solution and a precipitate with a lower pale layer and a upper green layer. The analyses of the solutions separated from the surface are summarized in Table 10.

**Table 10**

| Analyses of the metal contents | | |
|---|---|---|
| **Results** | **Cu %** | **Sn %** |
| M1 | 0.10 | 1.1 |
| M2 | 0.11 | 1.8 |

A conclusion may be drawn that heating is carried out prior to the oxalate treatment. Heating results in the precipitation of tin present in the spent stripper solution, to give tin compounds. Accordingly, a greater proportion of oxalic acid may react with copper to yield copper oxalate. The test also showed that copper oxalate precipitate was also clarified by the settling of tin particles.

### Test 5

In the test 5, different oxalic acid amounts were serially compared, either with or without nitric acid additions. The solutions were heated at 85°C for 2 hours. The samples were agitated in water bath after oxalic acid additions at about 60°C for 1 h. Volumes, and relative amounts of the precipitate and clear solution were determined from the samples, while visually estimating the reactions (Table 11). After precipitation, the precipitate was separated by centrifugation, weights were determined, and samples dried. Weighed and calculated results are summarized in Table 12. Partitioning of the metals between different phases were determined by analyzing metal contents of the samples, precipitate, and the solution. The results are shown in Table 13.

**Table 11**

| Separation of samples in volume % and as visual observations | | | | | | |
|---|---|---|---|---|---|---|
| **Test** | **HNO₃** | **Oxalic acid, %** | **20 h Clear solution, vol.%** | **20 h Settled slurry, vol.%** | **Solution** | **Precipitate** |
| **G** | 0% | 0 | 75 | 25 | green | pale |
| H | 0% | 3 | 70 | 30 | greenish | slightly greenish |
| **I** | 0% | 6 | 72 | 28 | brown | greenish |
| **L** | 5% | 0 | 72 | 28 | green | pale |
| **M** | 5% | 3 | 75 | 25 | greenish | slightly greenish |
| **N** | 5% | 6 | 71 | 29 | brown | greenish |

**Table 12**

| Weighted and calculated results from centrifugation (4500 rpm, 10 min) | | | | | |
|---|---|---|---|---|---|
| **Test** | **100% HNO₃** | **Oxalic acid, wt.%** | **Wet precipitate, wt.%** | **Moisture content of the precipitate, wt.%** | **Separated solution, wt.%** |
| **G** | 0% | 0 | 10.5 | 45.6 | 89.5 |
| **H** | 0% | 3 | 17.0 | 48.2 | 83.0 |
| **I** | 0% | 6 | 16.0 | 46.3 | 84.0 |
| **L** | 5% | 0 | 10.6 | 47.1 | 89.4 |
| **M** | 5% | 3 | 15.3 | 49.1 | 84.7 |
| **N** | 5% | 6 | 14.6 | 47.0 | 85.4 |

**Table 13**

| Partitioning of metals between different phases in samples G, H and I | | | |
|---|---|---|---|
| | **Sn%** | **Cu%** | **Fe %** |
| G precipitate | 32.6 | 0.23 | 2.5 |
| G solution | 2.1 | 0.44 | 1.3 |
| H precipitate | 29.2 | 0.33 | 2.5 |
| H solution | 0.44 | 0.39 | 1.2 |
| I precipitate | 28.7 | 1.9 | 2.4 |
| I solution | 0.72 | 0.13 | 1.2 |
| Initial solution | 5.3 | 0.42 | 1.5 |

### Test 6

In the test 6, additions of oxalic acid were higher than in the test 5. Otherwise, the conditions were the same. Settling was monitored more closely than in the test 5. The results are presented in the Tables 14 and 15.

**Table 14**

| Reaction conditions and results from centrifugation (4500 rpm, 10 min) | | | | | | | |
|---|---|---|---|---|---|---|---|
| **TEST** | Reaction temperature, °C | Reaction time, h | HNO₃, wt.% | Oxalic acid, % | Wet precipitate, wt.% | Moisture content of the precipitate, wt.% | Separated solution, wt.% |
| **0 test 1** | 85 | 2 | 0 | 0 | 10.9 | 46.3 | 89.1 |
| **O** | 85 | 2 | 0 | 6 | 16.3 | 47.2 | 83.7 |
| **P** | 85 | 2 | 0 | 7 | 15.6 | 46.3 | 84.4 |
| **Q** | 85 | 2 | 0 | 8 | 14.8 | 46.6 | 85.2 |
| | | | | | | | |
| **0 test 2** | 85 | 2 | 5 | 0 | 10.5 | 47.3 | 89.5 |
| **R** | 85 | 2 | 5 | 6 | 14.5 | 48.0 | 85.5 |
| **S** | 85 | 2 | 5 | 7 | 14.0 | 47.9 | 86.0 |
| **T** | 85 | 2 | 5 | 8 | 13.3 | 47.7 | 86.7 |

**Table 15**

| Clarification of the supernatant | | | | | | | | | | |
|---|---|---|---|---|---|---|---|---|---|---|
| Clarification time, h | 0.5 | 1 | 1.5 | 1.6 | 2 | 2.5 | 2.9 | 3.0 | 3.3 | **20** |
| 0 test 1, vol. % | 15 | 30 | 45 | | 54 | 62 | 65 | | | 76 |
| 0, vol. % | 18 | 32 | 46 | | 56 | 63 | 67 | | | 68 |
| P, vol. % | 18 | 30 | 42 | | 52 | 59 | 62 | | | 67 |
| Q, vol. % | 16 | 27 | 36 | | 45 | 51 | 57 | | | 70 |
| | | | | | | | | | | |
| 0 test 2, vol. % | 19 | 33 | | 46 | 56 | 63 | | 65 | 67 | 74 |
| R, vol. % | 14 | 27 | | 40 | 47 | 55 | | 60 | 64 | 71 |
| S, vol. % | 14 | 25 | | 37 | 45 | 52 | | 56 | 60 | 75 |
| T, vol. % | 13 | 24 | | 33 | 39 | 47 | | 52 | 55 | 72 |

The tables 14 and 15 show that with a Cu content of 0.4% by weight, the addition of 6% by weight of oxalic acid yields the best precipitate formation and fastest separation.

### Test 7

A bench scale test showed that a fresh stripper for tin with an addition of oxalic acid of 2.5% still performed in the stripping of tin. In the test, the tin stripper performed with a high stripping rate, the copper surfaces being clear and bright after the treatment. In comparison to samples without oxalic acid addition, the only difference due to oxalic acid was decoloration of the solution.

### Test 8a

### Large scale production tests

Tests in full production scale were performed in a reactor with a glass lining, having a capacity of 400 litres, as batches of 250 litres, at a temperature of 85°C, the reaction time being 2 hours. Nitric acid was added at the beginning of the test.

Thereafter in tests 3 and 4, oxalic acid was reacted for one hour at 60°C. Compositions of the samples were:
1. Original tin stripper
2. Original tin stripper + HNO₃ having a concentration of 61% in an amount of 8% by weight, based on the total weight
3. Original spent tin stripper + 6% of oxalic acid
4. Original spent tin stripper + 61% HNO₃ in an amount of 8% + 6% of oxalic acid

**Table 16**

| Weight distributions of the separated solid and liquid phases in pilot scale tests | | | | |
|---|---|---|---|---|
| | Batch 1 | Batch 2 | Batch 3 | Batch 4 |
| Recycled tin stripper, wt.% | 92 | 88 | 85 | 84 |
| Sn, %, based on the total amount | 25 | 22 | 16 | 13 |
| Cu, %, based on the total amount | 98 | 95 | 13 | 20 |
| | | | | |
| Precipitate, wt.% | 8 | 12 | 15 | 16 |
| Sn, %, based on the total amount | 75 | 78 | 84 | 87 |
| Cu, %, based on the total amount | 2 | 5 | 87 | 80 |

After tin separation, the solutions from the batches 1 and 2 were pooled in a container 1, while after tin and copper separation, the solutions from the batches 3 and 4 were pooled in a container 2. In table 17, the compositions thereof are compared to that of the original recycled tin stripper.

**Table 17**

| Compositions of the containers 1 and 2 after pooling | | | |
|---|---|---|---|
| | Recycled tin stripper | Purified | Purified |
| | | tin stripper, container 1 | tin stripper, container 2 |
| NO₃-N, % | 5.4 | 6.2 | 6.0 |
| Benzotriazole, % | 1.34 | 1.35 | 1.33 |
| Fe, % | 1.53 | 1.28 | 1.08 |
| CI, % | 0.87 | 0.65 | 0.67 |
| Sn, % | 5.36 | 1.28 | 0.77 |
| Cu, % | 0.43 | 0.43 | 0.08 |
| Total C, % | 0.91 | 0.92 | 1.86 |

On the basis of the carbon analysis it may be estimated that about 3.4% of oxalic acid remained in the solution pooled in the container 2.

The moisture, C, N, and Cl contents were first analyzed (Table 18) from the separated precipitates after centrifugation, and then, Sn, Fe, Cu, CI, Pb, Mg, and S were analyzed by X ray fluorescence analysis after drying of the samples (Table 19)

**Table 18**

| Analyses of wet precipitates | | | | |
|---|---|---|---|---|
| Precipitate samples | H₂O, % | Total C, % | NO₃-N, % | Cl, % |
| 1/2006 | 32.0 | 0.48 | 3.1 | 2.3 |
| 2/2006 | 31.7 | 0.47 | 3.5 | 2.3 |
| 3/2006 | 34.5 | 2.5 | 2.9 | 1.2 |
| 4/2006 | 33.6 | 2.3 | 3.3 | 1.3 |

**Table 19**

| XRF analyses of the dried samples | | | |
|---|---|---|---|
| | 2/2006 | 3/2006 | 4/2006 |
| Sn, % | 68.87 | 63.78 | 63.82 |
| Fe, % | 4.88 | 5.51 | 5.16 |
| Cu, % | 0.33 | 4.83 | 5.00 |
| Pb, % | 0.12 | 0.31 | 0.32 |
| Mg, % | 0 | 0.24 | 0.25 |
| S, % | 0.069 | 0.011 | 0.012 |

The results show that oxalic acid not only retains copper, but also other bivalent metals such as Pb²⁺, and Mg²⁺. Moreover it may be seen that the amounts of anions such as sulfates and chlorides are reduced by oxalic acid.

### Test 8b

### Production scale application experiments of recycled tin stripper in the production plant of printed circuit boards

Solutions of the test 9a from the containers 1 and 2 were supplemented with chemicals and fresh tin stripper in a ratio of 1:1, followed by the adjustment of the density (about 1.2 kg/I) and acidic normality (about 6 N) to typical values by dilution with water.

The recycled and supplemented tin stripper solution from the container 1 was tested by stripping tin from 2873 printed circuit board panels. The quality of the treated printed circuit boards was superior during the entire test, and thus the recycled solution was found to be suitable for stripping tin.

The test was continued by stripping tin from 4653 panels using recycled and supplemented tin stripper solution from the container 2. No quality problems were associated with this solution either, and thus the recycled solution was found to be suitable for stripping tin.

### Test 8c

### Regeneration of a tin stripper used twice

A sample was taken in the test 9b from the solution of the container 1, after tin stripping. This solution without oxalic acid is already once regenerated, and has twice passed the tin stripping process.

Part of the sample (A) was added with nitric acid to a concentration of 8% by weight (62 wt.% HNO₃), and heated at 85°C for 2 hours, followed by cooling to 50°C and the addition of oxalic acid to a concentration of 6% by weight while mixing for 15 minutes. The other part of the sample (B) was only added with nitric acid to a concentration of 8% by weight (62 wt.% HNO₃), and heated at 85°C for 2 hours.

In the test where a tin stripper used twice (STS, 11/2006) was regenerated by the addition of nitric acid and heating, the separated clear solution was analyzed (RL, 11/2006). The analyses showed that tin may also be removed from a stripper solution used twice.

**Table 20**

| | Total C, % | NO₃-N, % | CI, % | Cu, % | Fe, % | Sn, % | BTZ, % |
|---|---|---|---|---|---|---|---|
| STS, 11/2006 | 0.89 | 5.3 | 0.81 | 0.50 | 1.5 | 5.5 | 1.38 |
| RL, 11/2006 | 0.87 | 6.2 | 0.62 | 0.49 | 1.2 | 1.4 | 1.14 |

After the reactions, both samples were subjected to settling tests in flasks of 500 ml at 50°C.

**Table 21**

| Settling of twice recycled tin stripper | | |
|---|---|---|
| Settling time, h | A, clear layer, % by vol. | B, clear layer, % by vol. |
| 0 | 0 | 0 |
| 0.8 | 2.3 | 10.6 |
| 1.8 | 4.7 | 27.1 |
| 2.8 | 5.9 | 41.2 |
| 3.8 | 7.1 | 54.1 |
| 24 | 40.0 | 62.4 |
| 51 | 72.9 | 74.1 |

The solution in the sample B is clear, while slightly turbid in sample A due to oxalic acid reaction still proceeding, and slight mixing of the solution. Once the temperature is lowered at the end of the test to the room temperature, also the solution in sample A begins to become clear.

### Test 9

### Regeneration of a different spent tin stripper

Recycling of the tin stripper was applied after a somewhat different process where copper accumulation in the solution was considerably higher.

First the effect of the addition of nitric acid to a concentration of 5% was compared at 82°C. Then the effects of a slightly higher temperature (85°C) and longer residence time (3 h) were compared for the addition of nitric acid to concentrations 5, and 6%, respectively. In all tests, nitric acid was added as 62% nitric acid (about 8 and 10% by weight). In the test CID, more NOₓ gas was formed than in other tests, said gas formation causing remixing of the solid matter in the solution. The reaction conditions are presented in the Table 22.

**Table 22**

| Test conditions | | | |
|---|---|---|---|
| | Temp., °C | HNO₃, % | Time, h |
| CIA | 82 | 0 | 2 |
| CIB | 82 | 5 | 2 |
| CIC | 85 | 5 | 3 |
| CID | 85 | 6 | 3 |

Spent tin stripper used as the starting solution, and clear reaction solutions were analyzed. The results show that under appropriate conditions (e.g. CIC), while the copper content is high, tin is well removed.

**Table 23**

| Analyzed relative amounts in different reaction solutions | | | | | | |
|---|---|---|---|---|---|---|
| | Total C, % | NO₃-N, % | CI, % | Cu, % | Fe, % | Sn, % |
| CIO, spent tin stripper | 0.91 | 5.5 | 0.89 | 2.1 | 1.6 | 4.8 |
| CIA-RL, reaction solution | 0.91 | 5.7 | 0.81 | 2.2 | 1.6 | 2.6 |
| CIB-RL, reaction solution | 0.83 | 6.3 | 0.72 | 2.0 | 1.6 | 2.0 |
| CIC-RL, reaction solution | 0.89 | 6.4 | 0.69 | 2.0 | 1.3 | 0.94 |
| CID-RL, reaction solution | 0.87 | 6.5 | 0.68 | 1.9 | 1.3 | 0.93 |

Settling was monitored by leaving the reaction mixtures at 50°C for 22 hours. The relative amount of the tin slurries formed and settled in % by volume (CIA 14.7%; CIB 15.4%; CIC 20.6%; CID 25.2%; respectively by volume) correlated with the amount of tin removed from the solution. Best initial settling rates of the slurries (CIA 0.7-0.8 cm/h; CIB 1-1.1 cm/h; CIC 1.1-1.3 cm/h; CID 1.1-1.3 cm/h) were found in the tests CIC and CID. Surprisingly, at low temperatures, settling is improved by the nitric acid addition.

## Claims

1. Method for the treatment of a spent stripping solution for tin or a tin mixture by precipitation of dissolved or suspended metal compounds, **characterized in that** the efficiency of said precipitation is improved by heating the stripping solution at a temperature of 75 to 100°C, and by the addition of a reagent forming oxalate to said stripping solution, wherein the heating is performed prior to the addition of the reagent forming oxalate.

2. Method according to claim 1 wherein said spent stripping solution is heated at a temperature of 85 to 90°C for 0.5 to 3 hours.

3. Method according to claim 1 or 2 wherein the oxalate treatment is performed in a solution having a temperature of 30 to 60°C.

4. Method according to any of claims 1-3 wherein one or several reagent(s) forming oxalate is/are added to the stripping solution, said reagent(s) being selected from the group consisting of oxalic acid; as solid oxalic acid, or oxalic acid in the form of a solution, oxalate salt, or an organic compound reacting to yield oxalate under the conditions of the stripping solution.

5. Method according to any of claims 1-4 wherein precipitates of said metal compounds are separated from the solution.

6. Method according to any of claims 1-5 wherein the efficiency of the heating treatment is improved by the addition of nitric acid having a concentration of 60 to 100% prior to heating.

7. Method according to claim 6 wherein the precipitate of said metal compounds is separated from the solution after the nitric acid addition.

8. Method according to any of claims 1-7 wherein the precipitate of said metal compounds is separated from the solution during heating.

9. Method according to any of claims 1-8 wherein the precipitate of said metal compounds is separated from the solution after heating.

10. Method according to any of claims 1-9 wherein the precipitate of said metal compounds is separated from the solution during the oxalate addition.

11. Method according to any of claims 1-10 wherein the precipitate of said metal compounds is separated from the solution after the oxalate addition.

12. Method for producing a regenerated stripping solution for tin or tin mixtures, said solution comprising at least one inorganic acid, ferric ions, at least one organic acid, and at least one organic additive, **characterized in that** said regeneraration comprises a treatment according to the claim 1 with the following steps:
a. heating of the stripping solution at a temperature of 75 to 100°C for 0.5 to 3 hours,
b. addition of the reagent forming oxalate,
c. separation and removal of the precipitated matter,
d. addition of one or some of the acids, or additives mentioned to recover the desired tin stripping capacity.

13. Method according to claim 12 wherein nitric acid having a concentration of 60 to 100% is added prior to step a. to a concentration of 3 to 7% by weight, calculated as 100% nitric acid, based on the total weight of the stripping solution.

14. Method according to claims 12 or 13 comprising the recovery of the solid matter obtained in step c.

15. Method according to any of claims 12-14 wherein said steps a., b., c., and d. are successively performed in the order shown.

16. Use of the regenerated stripping solution obtained by the method according to any of claims 12-15 as a stripper solution for the production of printed circuit boards.

## Patentansprüche

1. Verfahren zur Behandlung einer verbrauchten Stripplösung für Zinn oder eine Zinnmischung durch Ausfällung von aufgelösten oder suspendierten Metallverbindungen, **dadurch gekennzeichnet, dass** die Effizienz der Ausfällung durch Erwärmen der Stripplösung bei einer Temperatur von 75 bis 100°C und durch die Zugabe eines Reagenzes, das Oxalat bildet, zu der Stripplösung verbessert wird, worin das Erwärmen vor der Zugabe des Reagenzes, das Oxalat bildet, durchgeführt wird.

2. Verfahren nach Anspruch 1, worin die verbrauchte Stripplösung bei einer Temperatur von 85 bis 90°C für 0,5 bis 3 Stunden erwärmt wird.

3. Verfahren nach Anspruch 1 oder 2, worin die Oxalatbehandlung in einer Lösung mit einer Temperatur von 30 bis 60°C durchgeführt wird.

4. Verfahren nach einem der Ansprüche 1 bis 3, worin ein oder mehrere Reagenzien, die Oxalat bilden, zu der Stripplösung gegeben wird/werden, wobei die Reagenzien ausgewählt sind aus der Gruppe bestehend aus Oxalsäure, fester Oxalsäure oder Oxalsäure in der Form einer Lösung, Oxalatsalz oder organische Verbindung, die unter Erhalt von Oxalat unter den Bedingungen der Stripplösung reagiert.

5. Verfahren nach einem der Ansprüche 1 bis 4, worin Präzipitate der Metallverbindungen von der Lösung getrennt werden.

6. Verfahren nach einem der Ansprüche 1 bis 5, worin die Effizienz der Erwärmungsbehandlung durch die Zugabe von Salpetersäure mit einer Konzentration von 60 bis 100% vor dem Erwärmen verbessert wird.

7. Verfahren nach Anspruch 6, worin das Präzipitat der Metallverbindungen von der Lösung nach der Salpetersäurezugabe getrennt wird.

8. Verfahren nach einem der Ansprüche 1 bis 7, worin das Präzipitat der Metallverbindungen von der Lösung während des Erwärmens getrennt wird.

9. Verfahren nach einem der Ansprüche 1 bis 8, worin das Präzipitat der Metallverbindungen von der Lösung nach Erwärmen getrennt wird.

10. Verfahren nach einem der Ansprüche 1 bis 9, worin das Präzipitat der Metallverbindungen von der Lösung während der Oxalatzugabe getrennt wird.

11. Verfahren nach einem der Ansprüche 1 bis 10, worin das Präzipitat der Metallverbindungen von der Lösung nach der Oxalatzugabe getrennt wird.

12. Verfahren zur Erzeugung einer regenerierten Stripplösung für Zinn oder Zinnmischungen, wobei die Lösung zumindest eine anorganische Säure, Ferriionen, zumindest eine organische Säure und zumindest ein organisches Additiv enthält, **dadurch gekennzeichnet, dass** die Regenerierung eine Behandlung gemäß Anspruch 1 mit den folgenden Schritten umfasst:
(a) Erwärmen der Stripplösung bei einer Temperatur von 75 bis 100°C für 0,5 bis 3 Stunden,
(b) Zugabe des Reagenzes, das Oxalat bildet,
(c) Trennung und Entfernung der ausgefällten Stoffe
(d) Zugabe von einer oder einigen der Säuren oder erwähnten Additiven, zum Wiedergewinnen der gewünschten Zinn-Strippfähigkeit.

13. Verfahren nach Anspruch 12, worin Salpetersäure mit einer Konzentration von 60 bis 100% vor dem Schritt a zu einer Konzentration von 3 bis 7 Gew.%, berechnet als 100% Salpetersäure, bezogen auf das Gesamtgewicht der Stripplösung, zugegeben wird.

14. Verfahren nach Anspruch 12 oder 13, umfassend die Wiedergewinnung des festen Stoffes, erhalten im Schritt c.

15. Verfahren nach einem der Ansprüche 12 bis 14, worin die Schritte a, b, c und d in der angegebenen Reihenfolge aufeinanderfolgend durchgeführt werden.

16. Verwendung der regenerierten Stripplösung, erhalten durch das Verfahren nach einem der Ansprüche 12 bis 15 als Stripplösung für die Erzeugung von gedruckten Schaltkreisen.

## Revendications

1. Procédé de traitement d'une solution stripping éteinte pour l'étain ou un mélange d'étain par précipitation de composés de métal dissous ou en suspension, **caractérisé par le fait que** l'efficacité de ladite précipitation est améliorée en chauffant la solution de stripping à une température de 75 à 100°C, et par l'addition d'un réactif formant de l'oxalate à ladite solution de stripping, dans lequel le chauffage est effectué avant l'addition du réactif formant de l'oxalate.

2. Procédé selon la revendication 1, dans lequel ladite solution de stripping éteinte est chauffée à une température de 85 à 90°C pendant de 0,5 à 3 heures.

3. Procédé selon la revendication 1 ou 2, dans lequel le traitement à l'oxalate est effectué dans une solution ayant une température de 30 à 60°C.

4. Procédé selon l'une quelconque des revendications 1 à 3, dans lequel un ou plusieurs réactifs formant de l'oxalate sont ajoutés à la solution de stripping, le ou lesdits réactifs étant sélectionnés parmi le groupe composé d'acide oxalique; tel qu'acide oxalique solide, ou acide oxalique sous forme de solution, sel oxalate, ou un composé organique réagissant pour donner de l'oxalate dans les conditions de la solution de stripping.

5. Procédé selon l'une quelconque des revendications 1 à 4, dans lequel les précipités desdits composés de métal sont séparés de la solution.

6. Procédé selon l'une quelconque des revendications 1 à 5, dans lequel l'efficacité du traitement de chauffage est amélioré par l'addition d'acide nitrique ayant une concentration de 60 à 100% avant le chauffage.

7. Procédé selon la revendication 6, dans lequel le précipité desdits composés de métal est séparé de la solution après l'addition d'acide nitrique.

8. Procédé selon l'une quelconque des revendications 1 à 7, dans lequel le précipité desdits composés de métal est séparé de la solution pendant le chauffage.

9. Procédé selon l'une quelconque des revendications 1 à 8, dans lequel le précipité desdits composés de métal est séparé de la solution après le chauffage.

10. Procédé selon l'une quelconque des revendications 1 à 9, dans lequel le précipité desdits composés de métal est séparé de la solution pendant l'addition d'oxalate.

11. Procédé selon l'une quelconque des revendications 1 à 10, dans lequel le précipité desdits composés de métal est séparé de la solution après l'addition d'oxalate.

12. Procédé de production d'une solution de stripping régénérée pour l'étain ou des mélanges d'étain, ladite solution comprenant au moins un acide inorganique, des ions ferriques, au moins un acide organique, et au moins un adjuvant organique, **caractérisé par le fait que** ladite régénération comprend un traitement selon la revendication 1 aux étapes suivantes :
a. chauffage de la solution de stripping à une température de 75 à 100°C pendant de 0,5 à 3 heures,
b. addition du réactif formant de l'oxalate,
c. séparation et enlèvement des substances précipitées,
d. addition d'un ou quelques-uns des acides ou adjuvants mentionnés, pour récupérer la capacité de stripping d'étain désirée.

13. Procédé selon la revendication 12, dans lequel de l'acide nitrique ayant une concentration de 60 à 100% est ajouté avant l'étape a., en une concentration de 3 à 7% en poids, calculée comme 100% d'acide nitrique, sur base du poids total de la solution de stripping.

14. Procédé selon les revendications 12 ou 13, comprenant la récupération de la substance solide obtenue à l'étape c.

15. Procédé selon l'une des revendications 12 à 14, dans lequel lesdites étapes a., b., c., et d., sont effectuées successivement dans l'ordre indiqué.

16. Utilisation de la solution de stripping régénérée obtenue par le procédé selon l'une des revendications 12 à 15 comme solution de stripping pour la production de plaques de circuit imprimé.
